# EUROPEAN PATENT SPECIFICATION

(11) **EP 1 586 115 B1**
(45) Date of publication and mention of the grant of the patent: **28.05.2008**
(21) Application number: 04704241.1
(22) Date of filing: 22.01.2004
(51) Int. Cl.: H01L 21/762, C09J 5/00

(54) **A LAYER TRANSFER METHOD**
SCHICHTÜBERTRAGUNGSVERFAHREN
PROCEDE DE TRANSFERT DE COUCHE

(30) Priority: 24.01.2003 FR 0300764; 22.05.2003 US 472437 P
(43) Date of publication of application: 19.10.2005
(73) Proprietor: S.O.I.Tec Silicon on Insulator Technologies, 38190 Bernin (FR); COMMISSARIAT A L'ENERGIE ATOMIQUE, 75752 Paris Cédex 15 (FR)
(72) Inventor: BRESSOT, Séverine, F-38210 La Rivière (FR); RAYSSAC, Olivier, F-38100 Grenoble (FR); ASPAR, Bernard, F-38140 Rives (FR)
(74) Representative: Bomer, Françoise Marie
(86) International application number: PCT/EP2004/000646
(87) International publication number: WO 2004/066380

(56) References cited:
- FR-A- 2 811 807
- PATENT ABSTRACTS OF JAPAN vol. 0152, no. 99 (E-1095), 30 July 1991 (1991-07-30) & JP 3 106052 A (HITACHI LTD; others: 01), 2 May 1991 (1991-05-02)
- PATENT ABSTRACTS OF JAPAN vol. 0120, no. 99 (E-594), 31 March 1988 (1988-03-31) & JP 62 229849 A (MITSUBISHI ELECTRIC CORP), 8 October 1987 (1987-10-08)
- PATENT ABSTRACTS OF JAPAN vol. 1999, no. 03, 31 March 1999 (1999-03-31) & JP 10 320851 A (TOSHIBA EMI LTD), 4 December 1998 (1998-12-04)

## Description

The present invention relates to a method of removing a peripheral zone of adhesive while using a layer of adhesive in the process of assembling and transferring a layer of material from a source substrate onto a support substrate for the purpose of fabricating a composite substrate for use in applications in the fields of optics, optoelectronics, or electronics.

Such methods are known from FR-A-2 811 807.

Novel techniques have recently been developed for transferring a layer of a material, in particular an optionally processed semiconductor material, from a first or "source" substrate onto a second or "support" substrate.

The term "processed layer" designates a layer of material that has undergone some or all of the steps of a technical method for forming electronic components.

Said transfer techniques use, for example, as the source substrate: a substrate that has been weakened by implanting atomic species, a substrate having a buried porous zone, a substrate with two layers bonded to each other by means of a bonding interface with controlled bonding energy so that said bonding is not definitive, or any substrate having a zone that is weaker than the substrate proper.

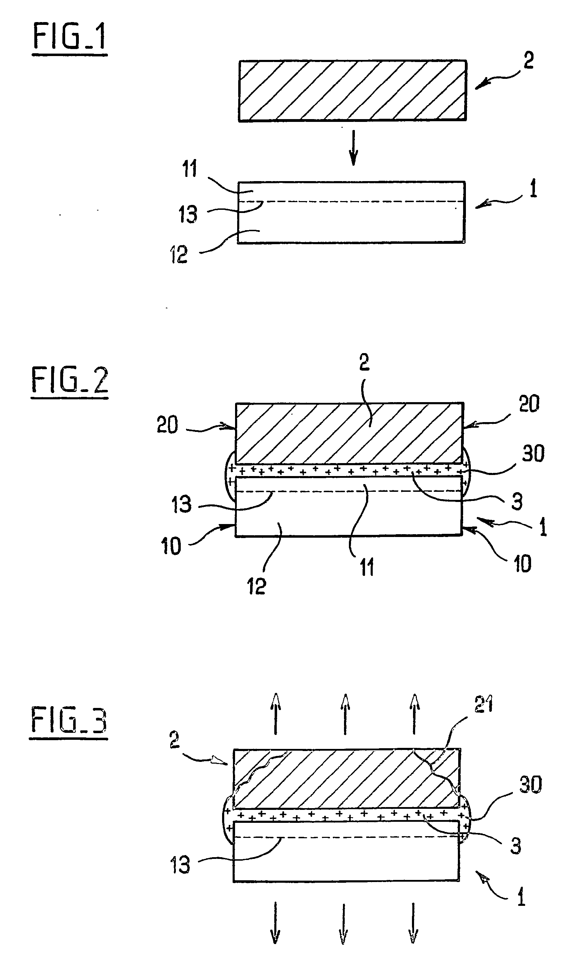

Said known techniques are described briefly below with reference to the accompanying Figures 1 to 3.

The source substrate 1 is weakened by one of the techniques mentioned above so as to have a preferential detachment zone 13 making the boundary between a layer 11 to be transferred and the remainder 12 of the substrate. This source substrate is brought into contact with a support substrate 2 (see Figure 1), then the layer to be transferred 11 is detached from the remainder 12 of the source substrate 1 along said detachment zone 13, for example by stresses of mechanical origin.

Said stresses of mechanical origin are generally tension and/or bending and/or shear stresses.

They can be applied, for example, by a pulling rig, a blade such as a guillotine, or by a plurality of blades introduced to the side of said stack of layers, at the detachment zone 13, or by a jet of fluid (liquid or gas) applied laterally at said detachment zone.

Application of said mechanical stresses encourages the propagation of a crack at the detachment zone 13.

When the two substrates 1 and 2 are applied one against each other by molecular bonding, i.e., without using adhesive or an adhesive film, transfer of the layer to be transferred 11 is possible providing the mechanical retention of said layer 11 on the source substrate 1 is below the mechanical retention of said layer 11 on the support substrate 2.

However, that condition is no longer satisfied if adhesive is used since the exact volume of adhesive deposited is difficult to control. Thus, as can be seen in Figure 2, the adhesive 3 very often projects out (flash) at 30 beyond the respective side faces 10, 20 (or sides) of substrates 1, 2 so that the periphery of the detachment zone 13 opening into the side face 10 of the source substrate 1 is masked completely or in part.

In addition, since said adhesive is generally cured, the curing also causes said adhesive flash 30 to harden.

It is then very difficult to detach the layer to be transferred 11 properly by applying mechanical stresses.

The mechanical force to be applied becomes very high, which may result in cleavage of at least one of the substrates and in particular of the support substrate 2 along fracture lines which no longer extend in the plane of the detachment zone 13, but in a random and unpredictable manner in the thickness of at least one of the substrates and in particular of said support substrate 2 (see Figure 3). Inside the substrate 2, the fracture lines are referenced 21.

The aim of the present invention is to overcome those disadvantages, and in particular to improve layer transfer methods, and to prevent excess adhesive deposited at the bonding interface between a source substrate and a support substrate from masking the attack edge of the detachment zone.

The object is achieved by means of a method of removing a peripheral zone of adhesive while using a layer of adhesive in the process of assembling and transferring a layer of material from a source substrate onto a support substrate for the purpose of fabricating a composite substrate for use in applications in the fields of electronics, optics, or optoelectronics, said source substrate presenting a detachment zone interposed between the layer of material to be transferred and the remainder of the source substrate.

According to the invention, the method comprises the successive steps consisting in:
a) depositing a layer of adhesive on the free surface referred to as the "front face" of the layer of material to be transferred or on the "front" face of the support substrate or on both front faces ;
b) applying said source substrate and said support substrate against each other, the front face of the support substrate facing the front face of the layer of material to be transferred;
c) causing only the "connection" zone of the layer of adhesive that extends facing said front face of the layer of material to be transferred to react so as to enable it to increase its mechanical holding properties;
d) detaching said layer to be transferred from the remainder of the source substrate along said detachment zone; and
removing the zone of the layer of adhesive situated at the periphery of said connection zone, said removing step optionally being performed on one or more occasions between steps b) and c), between steps c) and d), or after step d), and possibly if it is performed on a plurality of occasions, in part between steps a) and b).

Non-limiting, advantageous characteristics of the invention, taken alone or in combination, are as follows:
- the adhesive is photocurable on being exposed to light radiation, in that at least one of the substrates amongst the support substrate and the source substrate is transparent to the light radiation, and in that step c) consists in causing exclusively the connection zone of the adhesive layer to be cured from the rear face of the source substrate or from the rear face of the support substrate by being exposed to light rays through a mask for protecting from exposure the zone of the layer of adhesive that extends at the periphery of said connection zone;
- the adhesive is thermosetting, and in step c) consists in causing only the adhesive of said connection zone to be set by heating using localized heating means and then returning to a lower temperature, heating means being for exemple a laser beam;
- detachment step d) is performed by applying stress of mechanical origin;
- the layer of material to be transferred contains at least a portion of an electronic or an optoelectronic component;
- the detachment zone is a zone of weakness formed by implanting atomic species or formed by a porous layer;
- the detachment zone is formed by a releasable bonding interface;
- the detachment zone is a stop layer constituting a barrier to chemical and/or mechanical attack;
- the layer of material to be transferred, and the remainder of the source substrate are both made of silicon, and the releasable bonding interface is within or at the surface of a layer of silicon oxide.

Other characteristics and advantages of the invention become apparent from the following description of a preferred implementation of the invention. This description is made with reference to the accompanying drawings in which:
- Figures 1 to 3 are diagrams illustrating the various steps of a prior art method of transferring a layer;
- Figures 4 to 9 are diagrams illustrating the various steps of a first implementation of the layer transfer method of the invention;
- Figures 10 to 15 are diagrams illustrating a variant of the above-mentioned method; and
- Figures 16 to 19 are diagrams illustrating various steps of a second implementation of the layer transfer method.

These figures are diagrams in which the various layers and their thicknesses are not shown to scale and some have been deliberately enlarged for the purposes of clarification.

In the remainder of the description, the various substrates described are considered to be in the shape of a disk or a cylinder since that is the shape most frequently encountered. However, that feature is not limiting and said substrates could have other shapes.

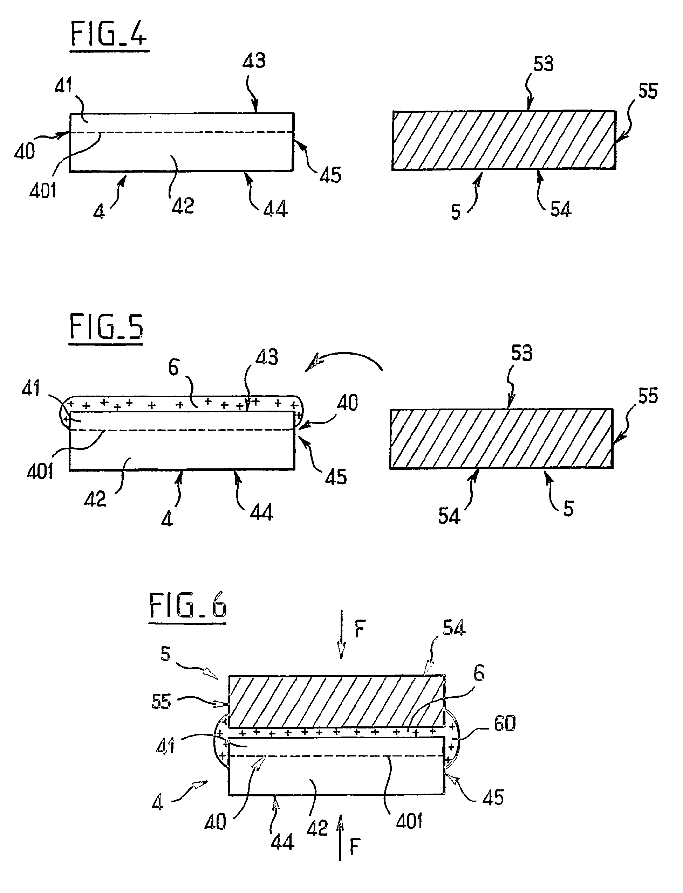

The invention falls within the category of methods of transferring a layer of material 41 deriving from a source substrate 4 onto a support substrate 5 during the fabrication of a composite substrate for applications in the fields of electronics, optics, and optoelectronics (see Figure 4). The term "composite" means that said substrate has a plurality of layers.

In the remainder of the description and claims, the terms "source substrate" 4 and "support substrate" 5 should be interpreted as encompassing both a singular substrate of a given material and a stack of layers of materials which may be of different kinds.

The source substrate 4 has a cylindrical side face 45, a face 43 termed the "front face" and an opposite face 44 termed the "rear face".

Further, said source substrate 4 has an internal zone 40 termed the "detachment zone", delimiting a layer 41 of material to be transferred, from the remainder 42 of the substrate.

The layer 41 of material to be transferred is situated beside the front face 43. It may contain all or part of an electronic or optoelectronic component, for example a component known as a microelectronic mechanical system (MEMS) or a micro-optoelectronic mechanical system (MOEMS).

The term "detachment zone" means in general manner a zone of the source substrate 4 along which the two layers situated on either side thereof will subsequently detach more easily from each other, particularly on application of a stress.

The detachment zone 40 may either be a zone of weakness 401 obtained by implanting atomic species or constituted by a porous zone, or it may be a releasable bonding interface 402, or it may be a stop layer for mechanical or chemical attack as described below, or indeed it may be the oxide layer of silicon on insulator (SOI) type substrate.

When the zone of weakness 401 is obtained by implanting atomic species within the source substrate 4, the layer 41 and the remainder of the substrate 42 are made out of the same material or out of different materials. The layer 41 may be constituted, for example, by one or more layers obtained by epitaxial growth or by a buffer layer, likewise obtained by epitaxial growth.

The implantation of atomic species is preferably carried out from the front face 43 of the layer 41 to be transferred, which is also the front face of the source substrate 4.

The term "implanting atomic species" means any bombardment of atomic, molecular, or ionic species that is capable of introducing said species into a material at a certain depth with respect to the bombarded surface 43, with a concentration maximum of said species in the vicinity of a certain depth, the depth being determined by the implantation energy of said species.

Atomic species can be implanted in said source substrate 4 using an ion beam implanter or a plasma immersion implanter, for example.

Preferably, said implantation is accomplished by ionic bombardment, and in advantageous manner, the implanted ionic species is hydrogen. Other ionic species can advantageously be used alone or in combination with hydrogen, for example rare gases (for example helium).

By way of example, reference can be made to the literature concerning the method known under the trade name "Smart Cut".

The zone of weakness 401 can also be constituted by a porous layer obtained, for example, during one of the steps of the method known under the trade name "ELTRAN" filed by Canon, described in particular in European patent EP-A-0 849 788.

In this case, the source substrate 4 is constituted by a stack of layers comprising at least one layer of material 41 obtained by epitaxial growth on a porous layer 401, which layer rests on the remainder 42 of the source substrate.

Finally, when the detachment zone 40 is constituted by a "releasable" bonding interface 402, said interface is interposed between the layer 41 to be transferred and the remainder 42 constituted by one or more layers.

The term "releasable" means that bonding is not definitive so that the layer 41 can subsequently be released from the remainder 42. In this regard, reference can, for example, be made to document FR-2 823 599 which describes a release method.

In a manner similar to that described above for the source substrate 4, the support substrate 5 has a cylindrical side face 55, a front face 53, and a rear face 54.

Said support substrate 5 acts to hold the assembly together mechanically.

The source substrate 4 and the support substrate 5 are intended to be applied against each other in the subsequent steps of the method, their respective front faces 43 and 53 being placed facing each other.

As shown in Figure 5, a layer of adhesive 6 is deposited on the front face 43 of the source substrate 4, i.e. on the front face of the layer 41 of material to be transferred. This adhesive 6 could equally well be deposited on the front face 53 of the support substrate 5, or on both front faces 43 and 53.

As shown in Figure 6, the two substrates 4 and 5 are then applied one against the other so that said layer of adhesive 6 is interposed between their respective front faces 43 and 53, and these two substrates 4 and 5 are pressed one against the other (arrow F). The excess 60 of adhesive 6 spills out onto the side faces 45 and 55 of said substrates 4 and 5.

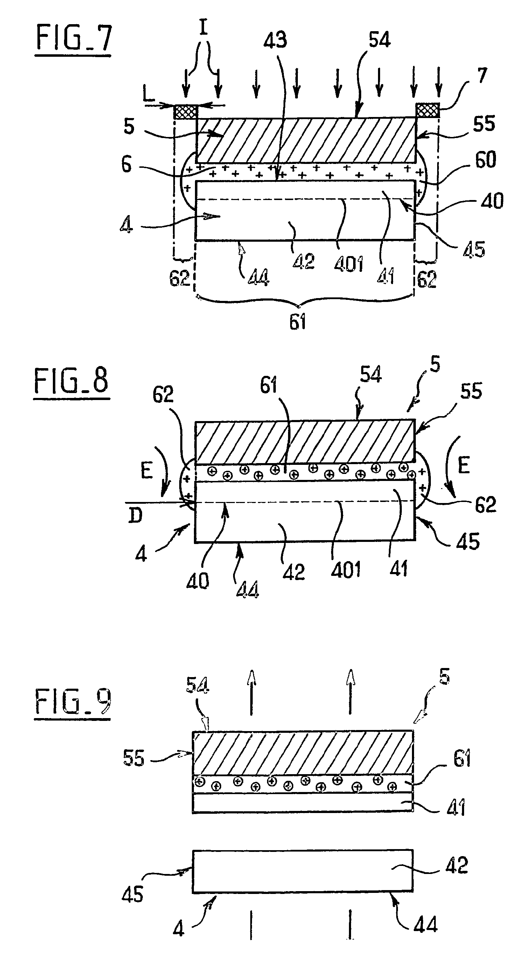

As shown in Figure 7, treatment is subsequently performed consisting in causing reaction to take place solely in the zone 61 of the layer of adhesive 6, referred to as the "connection zone", which extends facing the front face 43 of the layer of material to be transferred, so that in said zone the mechanical holding properties of the adhesive increase, i.e. the adhesive holds mechanically more strongly.

The adhesive 6 is preferably a curable adhesive and the above-mentioned treatment consists in curing it.

In the embodiment shown in Figures 4 to 9, the adhesive 6 is a photocurable adhesive, i.e. an adhesive suitable for curing and setting under the action of light radiation, for example ultraviolet (UV) radiation.

By way of example, mention can be made of a UV adhesive such as the adhesive known under the name VITRALIT 6127N and sold by the supplier ELECO PRODUITS, or a so-called "negative" resin.

Curing is then performed by exposure (arrows I) through a mask 7 of annular shape whose inside diameter corresponds at most to the diameter of the layer 41 of material to be transferred. This inside diameter could equally well be very slightly smaller than the diameter of the layer 41. The mask 7 protects from exposure the zone 62 of the layer of adhesive 6 extending to the outer periphery of the layer 41 of material to be transferred.

The mask 7 is placed substantially in the same plane as the rear face 54 of the support substrate 5.

The width L of the section of the annular mask 7 should be not less than and preferably greater than the thickness (the width) of the excess adhesive 60 on the side faces 45 and 55 of the two substrates.

The shape of the mask 7 is naturally adapted to the shape of the outer outline of the layer 41 to be transferred.

Exposure takes place from the rear face 54 of the support substrate 5, said substrate being transparent to light radiation of the kind suitable for curing the adhesive, and in particular ultraviolet radiation if the adhesive is UV-curable.

After exposure, only the zone 61 of the layer of adhesive 6 that extends facing the front face 43 of the layer 41 of material to be transferred is cured and set.

It should be observed that exposure could equally well be performed through the source substrate 4, providing that it is transparent to rays suitable for causing the adhesive 6 to react, in which case the mask 7 should be placed substantially in the same plane as the rear face 44.

Thereafter, the mask 7 is withdrawn and the non-cured peripheral annular zone 62 of the layer of adhesive 6 is removed (arrows E in Figure 8), e.g. by wiping the side faces 45 and 55 of the stack of substrates 4 and 5 using a cloth or by chemical cleaning using a suitable solvent that specifically dissolves the non-cured adhesive.

Finally, the layer to be transferred 41 is detached from the remainder 42 of the source substrate 4 along the zone of weakness 401, e.g. by applying stress of mechanical origin (see Figure 8, arrow D, and Figure 9). This is possible because there is no longer any trace of adhesive at the intersection between the zone of weakness 401 and the side face 45 of the source substrate 4.

By way of example, the stress of mechanical origin may be traction stress and/or bending stress and/or shear stress and it may be applied, for example, by means of a pulling rig, or by a blade, such as a guillotine, inserted from the side face 45 of the source substrate 4 into the zone of weakness 401, or indeed by a jet of fluid (liquid or gas) applied laterally against said zone 401.

By way of example, reference can be made to documents FR 2 796 491 and EP 0 849 788 which describes methods of detaching two layers one from the other, respectively by means of a jet of gas (air) and by means of a jet of liquid (water).

Detachment could also be performed by means of at least one of the following techniques which can be used singly or in combination with one another or with mechanical detachment, namely: applying stresses of electrical origin (applying an electrostatic or an electromagnetic field); or applying heat energy (radiation, convection, conduction, increasing pressure in microcavities), etc.

It should also be observed that the step of removing the zone 62 of non-cured adhesive could equally well be performed as a single step or in a plurality of steps after the substrates 4 and 5 have been applied one against the other and prior to the step of exposing the adhesive through the mask 7, or on the contrary after the detachment step of Figure 9.

In this last case, detachment is possible since even if adhesive remains at the intersection between the zone of weakness 401 and the side face 45, this adhesive 62 is not cured and it therefore does not impede access of a guillotine blade, for example, and it does not perform any mechanical holding function.

Finally, it should be observed that it would also be possible to remove a portion of the adhesive 6, e.g. a portion of adhesive which has flowed over the sides of the substrate, prior to applying the substrates 4 and 5 against each other.

The material constituting all or part of the source substrate 4 can be any material, in particular a semiconductor material, suitable for use in applications in the optical, electronic, and optoelectronic fields.

Purely by way of illustrative example, mention can be made of: silicon; silicon germanium; germanium; silicon carbide (SiC); and III-V materials, i.e. compounds in which one of the elements comes from column IIIa of the periodic table of elements, and the other comes from column Va, e.g. gallium arsenide (AsGa), or indium phosphide (InP).

If exposure takes place through the source substrate 4, then it must be transparent to the rays used. When using ultraviolet radiation, it could be constituted, for example, by: glass, fused silica, quartz, or a plastics material.

The support substrate 5 provides mechanical support. When exposure is performed through the support substrate, it is made of a material that is transparent to the rays.

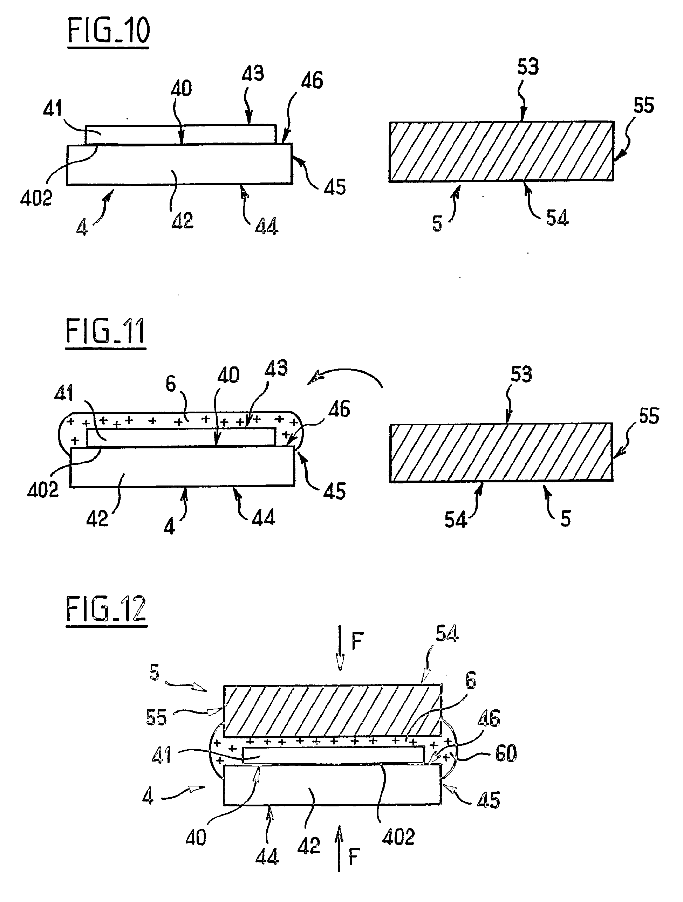

Figures 10 to 15 show a variant implementation of the steps of the method described above with reference to Figures 4 to 9, in which the support substrate 4 is referred to as a "releasable" SOI substrate. In such a substrate, the layer 41 of material to be transferred and the remainder 42 of the substrate are made of silicon and the zone of weakness 40 is constituted by a layer 402 of silicon oxide having one of its surfaces or its volume acting as the releasable bonding interface.

Figures 10 to 15 shows a variant implementation of the above-described method presenting certain steps that are similar to those described above with reference to Figures 4 to 9.

Elements that are identical between both implementations are given the same numerical references. Only the differences between the two methods are described below.

In the example shown in Figures 10 to 15, it is assumed that during bonding of the layer 41 on the layer 42, the bonding between the two layers was not strong enough at the periphery, and as a result a substantially annular peripheral ring zone 46 was formed on the layer 42. The layer 41 thus presents a diameter that is smaller than the diameter of the layer 42. In addition, the detachment zone 40 is a releasable bonding interface given reference 402.

During the step of depositing the layer of adhesive 6 or the step of applying the support substrate 5 against the SOI type substrate 4, the excess adhesive 60 flows not only towards the side faces 45 and 55 of the substrates 4 and 5, but also over the ring 46 (Figure 12).

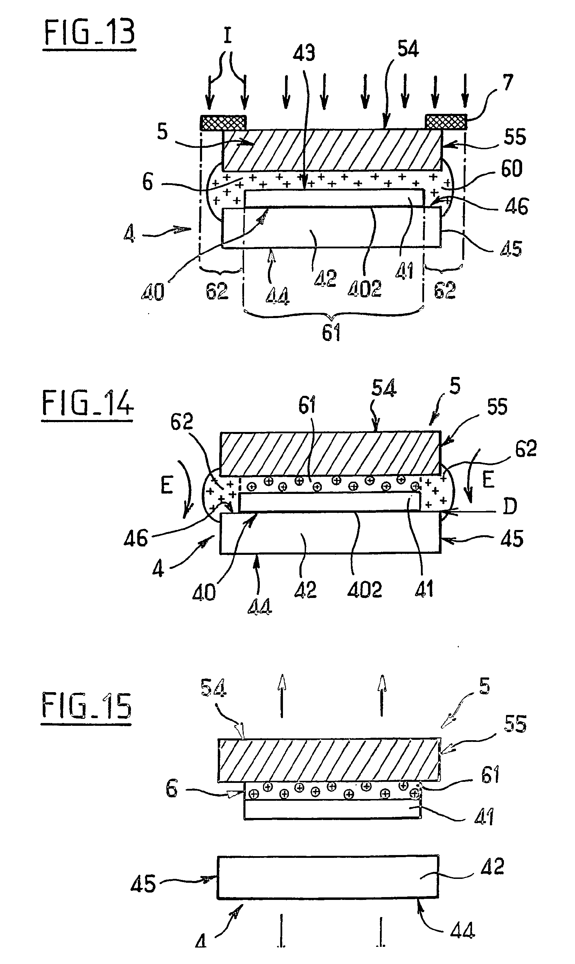

During the exposure step shown in Figure 13, it should be observed that the inside diameter of the annular mask 7 is less than or equal to the diameter of the layer 41 since it is necessary to avoid exposing the adhesive occupying the peripheral ring 46 (zone 62).

After exposure, and after the zone 62 of non-cured adhesive has been removed (see arrow E in Figure 14), it can be seen that the connection zone 61 of cured adhesive extends solely between the front face 43 of the layer 41 and the support 5, thus making it possible to realize the subsequent operation of implementing detachment at the oxide layer 402 (see arrow D in Figure 14, and Figure 15).

As for the method described above with reference to Figures 4 to 9, it is possible to remove the zone 62 of non-cured adhesive prior to exposure, or on the contrary after the detachment step of Figure 15.

In a variant implementation, the rear layer 42 is withdrawn by lapping and/or by chemical attack. The oxide layer 402 then acts as a stop layer for the lapping and/or as a selective barrier for chemical or chemical-mechanical attack. By way of example, tetramethyl hydroxylamine (TMAH) can be used for selectively etching a silicon layer 42 and not a silicon oxide layer 402.

In general, the method of the invention can be applied to a source substrate 4 presenting an intermediate layer having a surface or a volume that acts as a releasable bonding interface or as a stop barrier against chemical and/or mechanical attack.

In a second implementation of the invention, the adhesive 6 is a thermosetting adhesive. By way of example, it may be a wax or an epoxy adhesive.

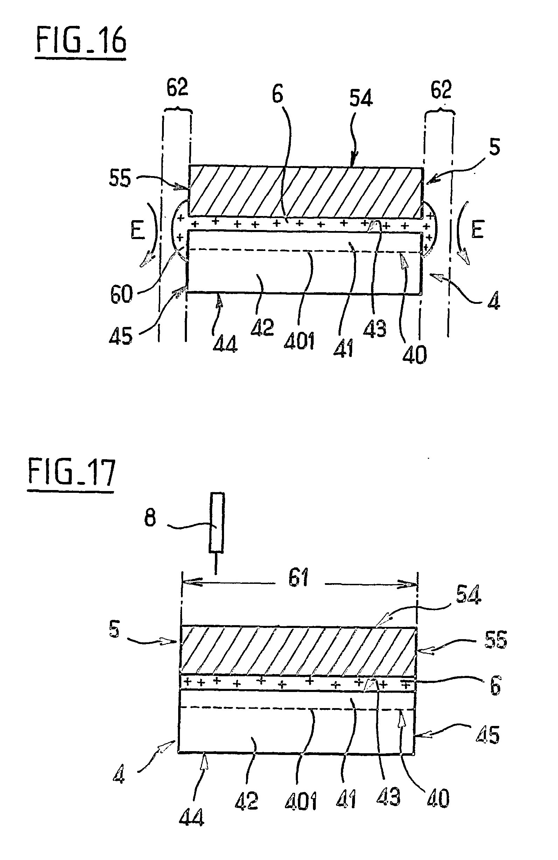

Under such circumstances, the steps of the method described with reference to Figures 4 to 6 are identical, and only the subsequent steps differ, and are shown in Figures 16 to 19.

By way of example, excess adhesive 60 is initially wiped off (Figure 16). Nevertheless, this step could also be performed subsequently.

The adhesive 6 is cured by localized heating of the zone 61 of the layer of adhesive 6 that is situated facing the front face 43 of the layer 41 to be transferred, followed by cooling (return to ambient temperature).

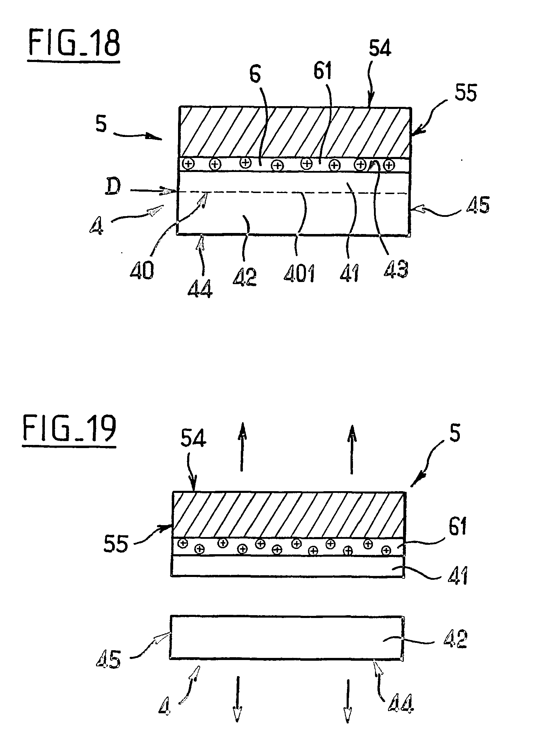

Localized heating can be performed, for example, by scanning using a laser beam 8 from the rear face 54 of the support substrate 5 (see Figures 17 and 18) or from the rear face 44 of the source substrate 4, the temperature at which heating is performed (about 200°C to 300°C) having no effect on the zone of weakness 401.

The localized heating may also be implemented by heating the entire stack of layers while simultaneously cooling its sides so that their temperature does not rise enough to enable the zone 62 of the layer of adhesive to cure.

The heating can also be performed using a lamp.

Detachment (see Figure 18) is performed as described for the preceding methods.

## Claims

1. A method of removing a peripheral zone (62) of adhesive while using a layer of adhesive (6) in the process of assembling and transferring a layer (41) of material from a source substrate (4) onto a support substrate (5) for the purpose of fabricating a composite substrate for use in applications in the fields of electronics, optics, or optoelectronics, said source substrate (4) presenting a detachment zone (40, 401, 402) interposed between the layer (41) of material to be transferred and the remainder (42) of the source substrate (4), the method being **characterized in that** it comprises the successive steps consisting in:
a) depositing a layer of adhesive (6) on the free surface (43) referred to as the "front face" of the layer (41) of material to be transferred or on the "front" face (53) of the support substrate (5) or on both front faces (43, 53);
b) applying said source substrate (4) and said support substrate (5) against each other, the front face (53) of the support substrate (5) facing the front face (43) of the layer (41) of material to be transferred;
c) causing only the "connection" zone (61) of the layer of adhesive (6) that extends facing said front face (43) of the layer (41) of material to be transferred to react so as to enable it to increase its mechanical holding properties;
d) detaching said layer (41) to be transferred from the remainder of the source substrate (42) along said detachment zone (40, 401, 402); and
removing the zone (62) of the layer of adhesive (6) situated at the periphery of said connection zone (61), said removing step optionally being performed on one or more occasions between steps b) and c), between steps c) and d), or after step d), and possibly if it is performed on a plurality of occasions, in part between steps a) and b).

2. A method according to claim 1, **characterized in that** the adhesive (6) is photocurable on being exposed to light radiation, **in that** at least one of the substrates amongst the support substrate (5) and the source substrate (4) is transparent to the light radiation, and **in that** step c) consists in causing exclusively the connection zone (61) of the adhesive layer (6) to be cured from the rear face (44) of the source substrate (4) or from the rear face (54) of the support substrate (5) by being exposed to light rays through a mask (7) for protecting from exposure the zone (62) of the layer of adhesive (6) that extends at the periphery of said connection zone (61).

3. A method according to claim 1, **characterized in that** the adhesive (6) is thermosetting, and **in that** in step c) consists in causing only the adhesive of said connection zone (61) to be set by heating using localized heating means (8) and then returning to a lower temperature.

4. A method according to claim 3, **characterized in that** the localized heating means (8) are a laser beam.

5. A method according to any preceding claim, **characterized in that** detachment step d) is performed by applying stress of mechanical origin.

6. A method according to any preceding claim, **characterized in that** the layer (41) of material to be transferred contains at least a portion of an electronic or an optoelectronic component.

7. A method according to any preceding claim, **characterized in that** the detachment zone is a zone of weakness (401) formed by implanting atomic species.

8. A method according to any one of claims 1 to 6, **characterized in that** the detachment zone is a zone of weakness (401) formed by a porous layer.

9. A method according to any one one of claims 1 to 6, **characterized in that** the detachment zone is formed by a releasable bonding interface (402).

10. A method according to any one of claims 1 to 6, **characterized in that** the detachment zone is a stop layer constituting a barrier to chemical and/or mechanical attack.

11. A method according to claim 9, **characterized in that** the layer (41) of material to be transferred, and the remainder of the source substrate (42) are both made of silicon, and **in that** the releasable bonding interface (402) is within or at the surface of a layer of silicon oxide.

## Patentansprüche

1. Verfahren zum Entfernen einer Randzone (62) eines Klebers bei der Verwendung einer Kleberschicht (6) bei dem Vorgang des Zusammensetzens und Übertragens einer Materialschicht (41) von einem Quellsubstrat (4) auf ein Trägersubstrat (5) zum Zweck der Herstellung eines zusammengesetzten Substrats für den Einsatz in Anwendungen in den Bereichen der Elektronik, Optik oder Optoelektronik, wobei das Quellsubstrat (4) eine Ablösungszone (40, 401, 402) hat, die zwischen der zu übertragenden Materialschicht (41) und dem Rest (42) des Quellsubstrats (4) liegt, wobei das Verfahren **dadurch gekennzeichnet ist, dass** es die aufeinander folgenden Schritte umfasst, die aus folgendem bestehen:
a) auftragen einer Kleberschicht (6) auf der freien Oberfläche (43) der zu übertragenden Materialschicht (41), die als "Vorderseite" bezeichnet wird, oder auf der "vorderen" Seite (53) des Trägersubstrats (5) oder auf beiden Vorderseiten (43, 53);
b) aneinander bringen des Quellsubstrats (4) und des Trägersubstrats (5), wobei die Vorderseite (53) des Trägersubstrats (5) zur Vorderseite (43) der zu übertragenden Materialschicht (41) schaut;
c) bewirken, dass nur die "Verbindungs"-Zone (61) der Kleberschicht (6), die sich über die Vorderseite (43) der zu übertragenden Materialschicht (41) erstreckt, reagiert, so dass sie dazu befähigt wird, ihre mechanischen Halteeigenschaften zu verstärken;
d) ablösen der zu übertragenden Schicht (41) von dem Rest des Quellsubstrats (42) entlang der Ablösezone (40, 401, 402); und
entfernen der Zone (62) der Kleberschicht (6), die sich am Rand der Verbindungszone (61) befindet, wobei der Entfernungsschritt optional bei einer oder mehreren Gelegenheiten zwischen den Schritten b) und c), zwischen den Schritten c) und d) oder nach Schritt d) ausgeführt wird, und möglicherweise, falls er bei mehreren Gelegenheiten ausgeführt wird, teilweise zwischen den Schritten a) und b) ausgeführt wird.

2. Verfahren nach Anspruch 1, **dadurch gekennzeichnet, dass** der Kleber (6) lichthärtend ist, indem er Lichtstrahlung ausgesetzt wird, wobei wenigstens eines der Substrate unter dem Trägersubstrat (5) und dem Quellsubstrat (4) für die Lichtstrahlung transparent ist und wobei Schritt c) darin besteht zu bewirken, dass ausschließlich die Verbindungszone (61) der Kleberschicht (6) über die Rückseite (44) des Quellsubstrats (4) oder über die Rückseite (54) des Trägersubstrats (5) gehärtet wird, indem sie Lichtstrahlen durch eine Maske (7) ausgesetzt wird, um die Zone (62) der Kleberschicht (6), die sich am Rand der Verbindungszone (61) erstreckt, vor der Belichtung zu schützen.

3. Verfahren nach Anspruch 1, **dadurch gekennzeichnet, dass** der Kleber (6) wärmehärtend ist und **dadurch, dass** Schritt c) daraus besteht zu bewirken, dass nur der Kleber der Verbindungszone (61) härtet, indem unter Verwendung lokaler Erwärmungsmittel (8) erwärmt und dann zu einer niedrigeren Temperatur zurück gekehrt wird.

4. Verfahren nach Anspruch 3, **dadurch gekennzeichnet, dass** die lokalen Erwärmungsmittel (8) ein Laserstrahl sind.

5. Verfahren nach einem der vorhergehenden Ansprüche, **dadurch gekennzeichnet, dass** der Ablöseschritt d) ausgeführt wird, indem eine Spannung mechanischen Ursprungs angewendet wird.

6. Verfahren nach einem der vorhergehenden Ansprüche, **dadurch gekennzeichnet, dass** die zu übertragende Materialschicht (41) wenigstens einen Teil einer elektronischen oder einer optoelektronischen Komponente beinhaltet.

7. Verfahren nach einem der vorhergehenden Ansprüche, **dadurch gekennzeichnet, dass** die Ablösezone eine Schwächezone (401) ist, die **dadurch** gebildet wird, dass Atomsorten implantiert werden.

8. Verfahren nach einem der Ansprüche 1 bis 6, **dadurch gekennzeichnet, dass** die Ablösezone eine Schwächezone (401) ist, die durch eine poröse Schicht gebildet wird.

9. Verfahren nach einem der Ansprüche 1 bis 6, **dadurch gekennzeichnet, dass** die Ablösezone eine Schwächezone (401) ist, die durch eine auflösbare Bondingschnittstelle (402) gebildet wird.

10. Verfahren nach einem der Ansprüche 1 bis 6, **dadurch gekennzeichnet, dass** die Ablösezone eine Stoppschicht ist, die eine Sperre für einen chemischen und/oder mechanischen Angriff bildet.

11. Verfahren nach Anspruch 9, **dadurch gekennzeichnet, dass** die zu übertragende Materialschicht (41) und der Rest des Quellsubstrats (42) beide aus Silizium hergestellt sind, und **dadurch, dass** sich die auflösbare Bondingschnittstelle (402) innerhalb oder an der Oberfläche einer Siliziumoxid-Schicht befindet.

## Revendications

1. Procédé d'élimination d'une zone périphérique (62) de colle lors de l'assemblage à l'aide d'une couche de colle (6) et du transfert d'une couche (41) de matériau issue d'un substrat source (4), sur un substrat support (5), pour la fabrication d'un substrat composite destiné à des applications dans les domaines de l'électronique, l'optique ou l'optoélectronique, ledit substrat source (4) présentant une zone de détachement (40, 401, 402) intercalée entre la couche de matériau à transférer (41) et le reste (42) du substrat source (4), ce procédé étant **caractérisé en ce qu'**il comprend les étapes successives consistant à :
- a) déposer une couche de colle (6) sur la surface libre (43) dite "face avant" de la couche de matériau à transférer (41) ou sur la face "avant" (53) du substrat support (5) ou sur les deux faces avants (43, 53),
- b) appliquer ledit substrat source (4) et ledit substrat support (5) l'un contre l'autre, la face avant (53) du substrat support (5) étant en regard de la face avant (43) de la couche de matériau à transférer (41),
- c) faire réagir exclusivement la "zone liaison" (61) de la couche de colle (6), s'étendant en regard de ladite face avant (43) de la couche de matériau à transférer (41), pour lui permettre d'augmenter ses propriétés de tenue mécanique,
- d) détacher ladite couche à transférer (41), du reste du substrat source (42), le long de ladite zone de détachement (40, 401, 402),et
à éliminer la zone (62) de la couche de colle (6) située à la périphérie de ladite zone de liaison (61), cette étape d'élimination pouvant être effectuée de façon optionnelle en une seule ou en plusieurs fois entre les étapes b) et c), entre les étapes c) et d) ou après l'étape d) et éventuellement lorsqu'elle est effectuée en plusieurs fois, pour partie entre les étapes a) et b).

2. Procédé selon la revendication 1, **caractérisé en ce que** la colle (6) est photoréticulable sous l'action d'une exposition à un rayonnement lumineux, **en ce qu'**au moins l'un des substrats parmi le substrat support (5) et le substrat source (4) est transparent au rayonnement lumineux et **en ce que** l'étape c) consiste à faire réticuler exclusivement la zone de liaison (61) de la couche de colle (6) depuis la face arrière (44) du substrat source (4) ou depuis la face arrière (54) du substrat support (5), par insolation aux rayons lumineux, à travers un masque (7) destiné à isoler de l'insolation la zone (62) de la couche de colle (6) s'étendant à la périphérie de ladite zone de liaison (61).

3. Procédé selon la revendication 1, **caractérisé en ce que** la colle (6) est thermoréticulable et **en ce que** l'étape c) consiste à effectuer la réticulation exclusive de la colle de ladite zone de liaison (61) par chauffage à l'aide de moyens de chauffage localisé (8) puis retour à une température inférieure.

4. Procédé selon la revendication 3, **caractérisé en ce que** les moyens de chauffage localisé (8) sont un faisceau laser.

5. Procédé selon l'une quelconque des revendications précédentes, **caractérisé en ce que** l'étape d) de détachement est effectuée par application d'une contrainte d'origine mécanique.

6. Procédé selon au moins l'une des revendications précédentes, **caractérisé en ce que** la couche (41) de matériau à reporter contient au moins une partie d'un composant électronique ou opto-électronique.

7. Procédé selon l'une quelconque des revendications précédentes, **caractérisé en ce que** la zone de détachement est une zone de fragilisation (401) formée par implantation d'espèces atomiques.

8. Procédé selon l'une quelconque des revendications 1 à 6, **caractérisé en ce que** la zone de détachement est une zone de fragilisation (401) formée d'une couche poreuse.

9. Procédé selon l'une quelconque des revendications 1 à 6, **caractérisé en ce que** la zone de détachement est formée d'une interface de collage démontable (402).

10. Procédé selon l'une quelconque des revendications 1 à 6, **caractérisé en ce que** la zone de détachement est une couche d'arrêt formant barrière à une attaque mécanique et/ou chimique.

11. Procédé selon la revendication 9, **caractérisé en ce que** la couche de matériau à transférer (41) et le reste (42) du substrat source sont tous les deux en silicium et **en ce que** l'interface de collage démontable (402) est dans ou en surface d'une couche d'oxyde de silicium.
